# EUROPEAN PATENT APPLICATION

(11) **EP 4 809 865 A1**
(43) Date of publication of application: **23.09.2026**
(21) Application number: 26158125.0
(22) Date of filing: 12.02.2026
(51) Int. Cl.: A47B 88/40, H05K 7/14

(54) **SLIDE RAIL ASSEMBLY**

(30) Priority: 19.03.2025 TW 114110630
(71) Applicant: King Slide Works Co., Ltd., Kaohsiung City 821010 (TW); King Slide Technology Co., Ltd., Kaohsiung City 821011 (TW)
(72) Inventor: CHEN, Ken-Ching, 821010 Kaohsiung City (TW); YANG, Shun-Ho, 821010 Kaohsiung City (TW); YEH, Chih-Hsin, 821010 Kaohsiung City (TW); WANG, Chun-Chiang, 821010 Kaohsiung City (TW)
(74) Representative: Viering, Jentschura & Partner mbB Patent- und Rechtsanwälte

(57) **Abstract**

A slide rail assembly (20) includes a first rail (22), a second rail (24), a first auxiliary member (26) and a second auxiliary member (28). The first auxiliary member (26) is movably mounted to one of the first rail (22) and the second rail (24). The second auxiliary member (28) is mounted to the other one of the first rail (22) and the second rail (24) . During a process of the second rail (24) being moved relative to the first rail (22) from a predetermined position along a predetermined direction with the first auxiliary member (26) being located at a first working position, a guiding structure of the first auxiliary member (26) and a guiding feature of the second auxiliary member (28) are configured to contact each other in order to reduce speed of the second rail (24) relative to the first rail (22) along the predetermined direction.

## Description

### Field of the Invention

The present invention is related to a slide rail assembly.

### Background of the Invention

Generally, a slide rail assembly comprises a first rail and a second rail movable relative to each other. In order to protect the slide rail assembly and a carried object carried by the slide rail assembly during maintenance from being damaged caused by impact, the first rail and the second rail are usually arranged with corresponding structures respectively. When the second rail is moved a predetermined distance relative to the first rail, the corresponding structures are configured to contact each other in order to stop or slow down the second rail, so as to prevent the second rail from moving too fast and causing unexpected impact. For example, U.S. Patent number US 10,781,855 B2 discloses such arrangement.

However, for different market requirements, it is important to develop various products.

### Summary of the Invention

This in mind, the present invention aims at providing a slide rail assembly.

This is achieved by a slide rail assembly according to claim 1. The dependent claims pertain to corresponding further developments and improvements.

As will be seen more clearly from the detailed description following below, the claimed slide rail assembly comprises a first rail, a second rail, a first auxiliary member and a second auxiliary member. The second rail is longitudinally movable relative to the first rail. The first auxiliary member is movably mounted to one of the first rail and the second rail, and the first auxiliary member comprises a first guiding structure and a second guiding structure. The second auxiliary member is mounted to the other one of the first rail and the second rail, and the second auxiliary member comprises a first guiding feature and a second guiding feature. During a process of the second rail being moved relative to the first rail from a first predetermined position along a first predetermined direction with the first auxiliary member being located at a first working position, the first guiding structure of the first auxiliary member and the first guiding feature of the second auxiliary member are configured to contact each other in order to reduce speed of the second rail relative to the first rail along the first predetermined direction. When the second auxiliary member crosses the first auxiliary member, the second rail is movable relative to the first rail to a second predetermined position. During a process of the second rail being moved relative to the first rail from the second predetermined position along a second predetermined direction opposite to the first predetermined direction with the first auxiliary member being located at the first working position, the second guiding structure of the first auxiliary member and the second guiding feature of the second auxiliary member are configured to contact each other in order to reduce speed of the second rail relative to the first rail along the second predetermined direction. During a process of the second rail being moved relative to the first rail from the second predetermined position along the second predetermined direction with the first auxiliary member being located at a second working position different from the first working position, the second guiding structure of the first auxiliary member does not contact with the second guiding feature of the second auxiliary member.

### Brief Description of the Drawings

In the following, the invention is further illustrated by way of example, taking reference to the accompanying drawings thereof:
FIG. 1 is a diagram showing a slide rail assembly according to an embodiment of the present invention;
FIG. 2 is an exploded view of the slide rail assembly according to the embodiment of the present invention;
FIG. 3 is a diagram showing a second rail of the slide rail assemblies being located at a first predetermined position relative to a first rail according to the embodiment of the present invention;
FIG. 4 is a diagram showing the second rail of the slide rail assemblies being moved along a first predetermined direction relative to the first rail according to the embodiment of the present invention;
FIG. 5 is a diagram showing the second rail of the slide rail assemblies being further moved along the first predetermined direction relative to the first rail according to the embodiment of the present invention;
FIG. 6 is a diagram showing the second rail of the slide rail assemblies being further moved along the first predetermined direction to a second predetermined position relative to the first rail according to the embodiment of the present invention;
FIG. 7 is a diagram showing the second rail of the slide rail assemblies being moved along a second predetermined direction relative to the first rail according to the embodiment of the present invention;
FIG. 8 is a diagram showing the second rail of the slide rail assemblies being located at the second predetermined position relative to the first rail with a first auxiliary member being located at a first working position according to the embodiment of the present invention; and
FIG. 9 is a diagram showing the second rail of the slide rail assemblies being located at the second predetermined position relative to the first rail with the first auxiliary member being located at a second working position according to the embodiment of the present invention.

### Detailed Description

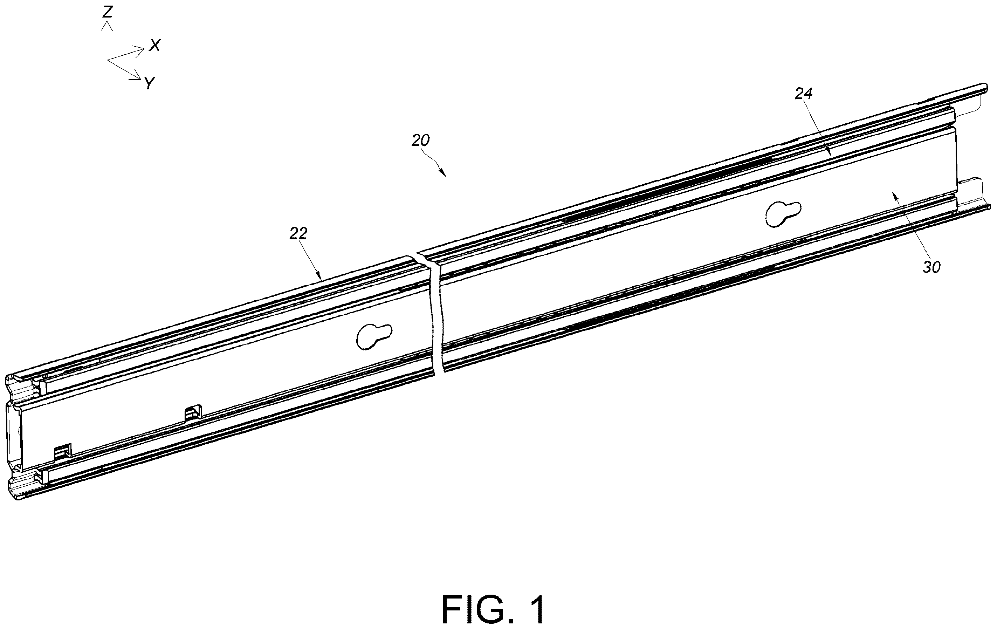

As shown in FIG. 1, FIG. 2 and FIG. 3, a slide rail assembly 20 comprises a first rail 22, a second rail 24, a first auxiliary member 26 and a second auxiliary member 28 according to an embodiment of the present invention. Preferably, the slide rail assembly 20 further comprises a third rail 30. The second rail 24 (such as a middle rail) is movably mounted between the first rail 22 (such as an outer rail) and the third rail 30 (such as an inner rail) . The first rail 22, the second rail 24 and the third rail 30 are longitudinally movable relative to each other. In the present invention, the X axis is a longitudinal direction (or a length direction of the slide rail assembly), the Y axis is a transverse direction (or a lateral direction of the slide rail assembly), and the Z axis is a vertical direction (or a height direction of the slide rail assembly).

The first rail 22 has a first end part 22a and a second end part 22b opposite to each other, such as a front end part and a rear end part, but the present invention is not limited thereto. The first rail 22 comprises a first wall 32a, a second wall 32b, and a longitudinal wall 34 connected between the first wall 32a and the second wall 32b of the first rail 22. The first wall 32a, the second wall 32b, and the longitudinal wall 34 of the first rail 22 together define a first passage 36 configured to accommodate the second rail 24.

The second rail 24 has a first end part 24a and a second end part 24b opposite to each other, such as a front end part and a rear end part, but the present invention is not limited thereto. The second rail 24 comprises a first wall 38a, a second wall 38b, and a longitudinal wall 40 connected between the first wall 38a and the second wall 38b of the second rail 24. The first wall 38a, the second wall 38b, and the longitudinal wall 40 of the second rail 24 together define a second passage 42 configured to accommodate the third rail 30.

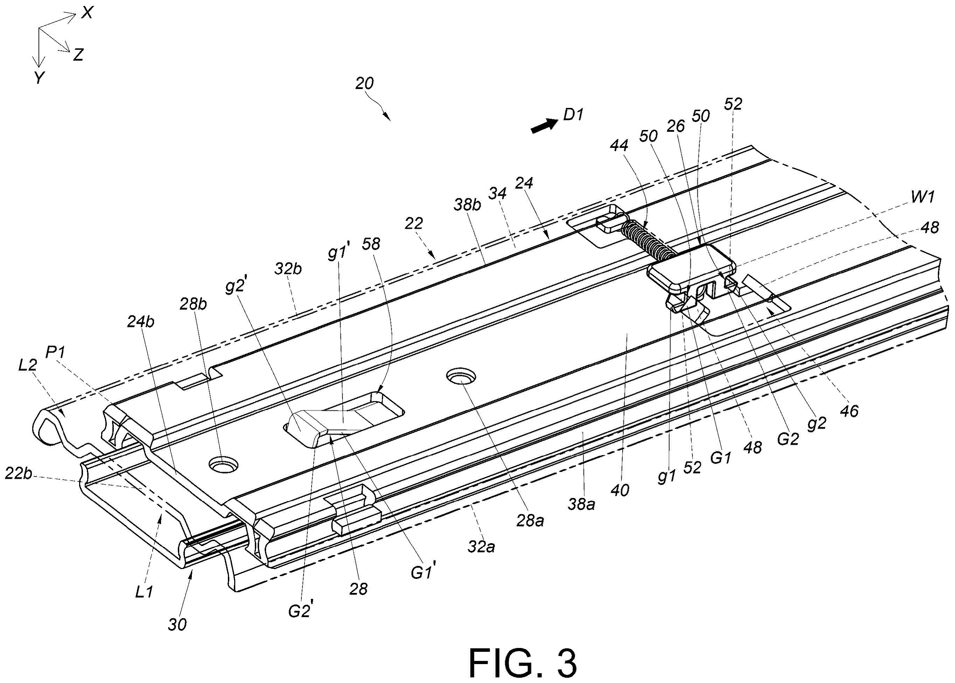

The first auxiliary member 26 is movably mounted to one of the first rail 22 and the second rail 24. In the present embodiment, the first auxiliary member 26 is movably mounted to the first rail 22, but the present invention is not limited thereto. The first auxiliary member 26 comprises a first guiding structure G1 and a second guiding structure G2. Each of the first guiding structure G1 and the second guiding structure G2 has an inclined surface or a curved surface. In the present embodiment, the first guiding structure G1 has a first inclined surface g1, and the second guiding structure G2 has a second inclined surface g2 (as shown in FIG. 3). However, in other embodiments of the present invention, the first guiding structure G1 can have a first curved surface, and the second guiding structure G2 can have a second curved surface, but the present invention is not limited thereto.

Preferably, the slide rail assembly 20 further comprises an elastic member 44. The first auxiliary member 26 is configured to be held at a first working position W1 (as shown in FIG. 3) in response to an elastic force of the elastic member 44. The elastic member 44 is mounted (such as connected) between the first rail 22 and the first auxiliary member 26.

Preferably, the first rail 22 has a first side L1 and a second side L2 opposite to each other, such as an inner side and an outer side. The longitudinal wall 34 of the first rail 22 is formed with an opening 46 communicating with the first side L1 and the second side L2 of the first rail 22, and the opening 46 is configured to accommodate the first auxiliary member 26.

Preferably, the first rail 22 comprises at least one limiting part 48, and the limiting part 48 is configured to limit a moving range of the first auxiliary member 26 (as shown in FIG. 3). In the present embodiment, the limiting part 48 is extended from and bent relative to the longitudinal wall 34 of the first rail 22, but the present invention is not limited thereto.

Preferably, the first auxiliary member 26 and the first rail 22 are respectively arranged with a first holding feature 50 and a second holding feature 52 fitting each other to movably mount the first auxiliary member 26 to the first rail 22. In the present embodiment, the first auxiliary member 26 is arranged with a pair of first holding features 50, and the longitudinal wall 34 of the first rail 22 is arranged with a pair of second retaining features 52 adjacent to the opening 46.

Preferably, one of the first holding feature 50 and the second holding feature 52 is formed with a groove, and the other of the first holding feature 50 and the second holding feature 52 is formed with an extension wall. In the present embodiment, the first holding feature 50 is formed with a groove, and the second holding feature 52 is formed with an extension wall configured to be extended into the groove, such that the first holding feature 50 and the second holding feature 52 are configured to hold each other, but the present invention is not limited thereto. Furthermore, stability of the first auxiliary member 26 moving relative to the first rail 22 can be improved through such arrangement of the first holding feature 50 and the second holding feature 52.

Preferably, the first side L1 of the first rail 22 is formed with the first passage 36 configured to accommodate the second rail 24.

Preferably, the second auxiliary member 28 is arranged on the other one of the first rail 22 and the second rail 24. In the present embodiment, the second auxiliary member 28 is mounted to the second rail 24, but the present invention is not limited thereto. The second auxiliary member 28 comprises a first guiding feature G1' and a second guiding feature G2'. Each of the first guiding feature G1' and the second guiding feature G2' has an inclined surface or a curved surface. In the present embodiment, the first guiding feature G1' has a first inclined surface g1', and the second guiding feature G2' has a second inclined surface g2' (as shown in FIG. 3). However, in other embodiments of the present invention, the first guiding feature G1' can have a first curved surface, and the second guiding feature G2' can have a second curved surface, but the present invention is not limited thereto.

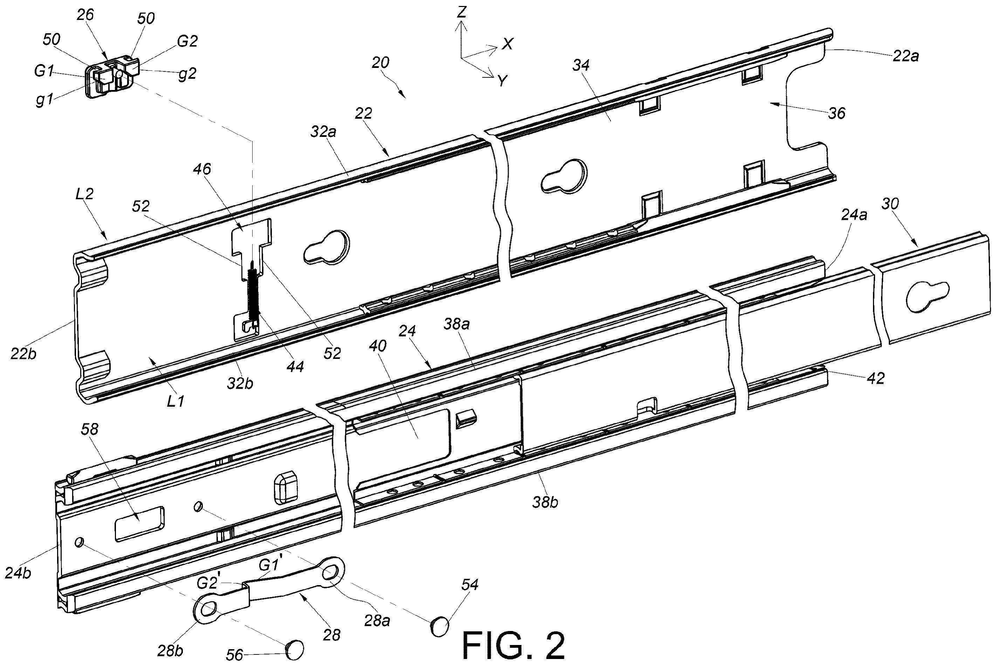

Preferably, the second auxiliary member 28 has a first end 28a and a second end 28b opposite to each other, such as a front end and a rear end. The first end 28a and the second end 28b of the second auxiliary member 28 are configured to be connected to the longitudinal wall 40 of the second rail 24 (as shown in FIG. 2) through a first connecting member 54 and a second connecting member 56 respectively, and the first guiding feature G1' and the second guiding feature G2' are located between the first end 28a and the second end 28b of the second auxiliary member 28.

Preferably, the longitudinal wall 40 of the second rail 24 is formed with a through hole 58 communicating with two opposite sides of the second rail 24. The first guiding feature G1' and the second guiding feature G2' of the second auxiliary member 28 correspond to the through hole 58. The first guiding feature G1' and the second guiding feature G2' are extended from one side of the second rail 24 to the other side of the second rail 24 by passing through the through hole 58, such that the first guiding feature G1' and the second guiding feature G2' are adjacent to the longitudinal wall 34 of the first rail 22 (as shown in FIG. 3).

Preferably, the second auxiliary member 28 is an elastic component, such as a spring sheet, but the present invention is not limited thereto. Furthermore, the first guiding feature G1' and the second guiding feature G2' are connected to each other. The first guiding feature G1' is extended from the first end 28a and bent at a first predetermined angle relative to the longitudinal wall 40 of the second rail 24. On the other hand, the second guiding feature G2' is extended from the second end 28b and bent at a second predetermined angle relative to the longitudinal wall 40 of the second rail 24. In the present embodiment, the first predetermined angle is smaller than the second predetermined angle, such that a slope of the first guiding feature G1' is smaller than a slope of the second guiding feature G2', but the present invention is not limited thereto. The aforementioned arrangement can provide resistant forces with different magnitudes in different directions. In other embodiments of the present invention, the first predetermined angle can be equal to the second predetermined angle in order to provide resistant forces with identical magnitude, but the present invention is not limited thereto.

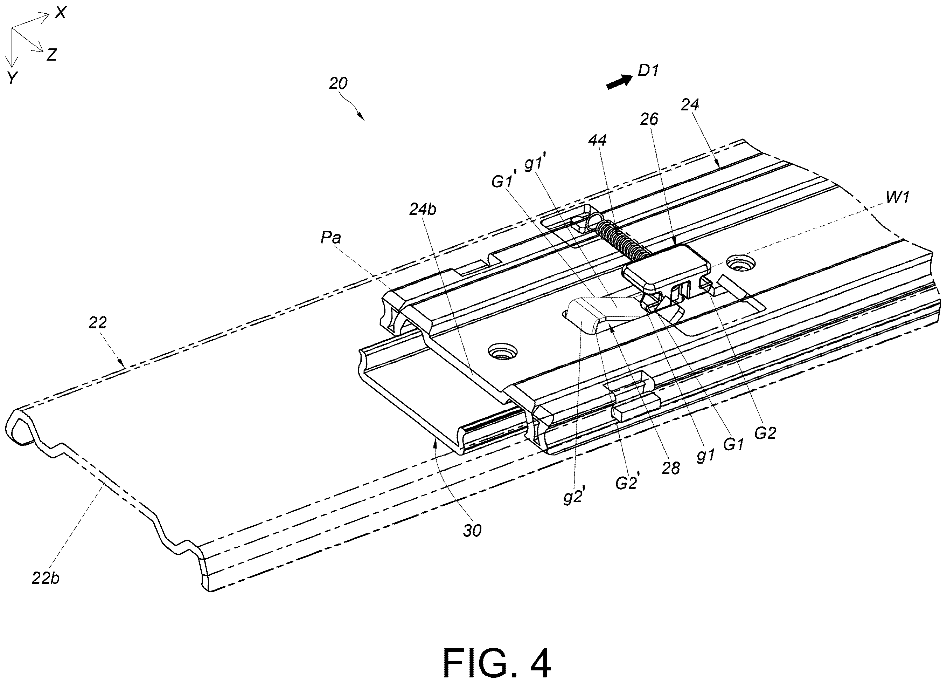

As shown in FIG. 3 and FIG. 4, when the first auxiliary member 26 is located at the first working position W1, the first auxiliary member 26 is aligned with the second auxiliary member 28 along the longitudinal direction to correspond to each other. During a process of the second rail 24 being longitudinally moved relative to the first rail 22 from a first predetermined position P1 (such as a retracted position as shown in FIG. 3, but the present invention is not limited thereto) along a first predetermined direction D1 (such as an opening direction)with the first auxiliary member 26 being located at the first working position W1, the first inclined surface g1 of the first guiding structure G1 of the first auxiliary member 26 and the first inclined surface g1' of the first guiding feature G1' of the second auxiliary member 28 are configured to contact each other (as shown in FIG. 4) in order to reduce speed of the second rail 24 (and the third rail 30) relative to the first rail 22 along the first predetermined direction D1.

Moreover, if a force applied by a user to the second rail 24 along the first predetermined direction D1 is not greater than a resistant force along a second predetermined direction D2 (such as a retracting direction), which is opposite to the first predetermined direction D1, generated through the first inclined surface g1 of the first guiding structure G1 of the first auxiliary member 26 contacting the first inclined surface g1' of the first guiding feature G1' of the second auxiliary member 28, the movement of the second rail 24 relative to the first rail 22 along the first predetermined direction D1 is stopped, such that the second rail 24 is stopped at a first stop position Pa (as shown in FIG. 4). According to such arrangement, the user can easily perform maintenance operations to the second rail 24 (and/or a carried object carried by the third rail 30), but the purpose of the second rail 24 being stopped at the first stop position Pa is not limited thereto.

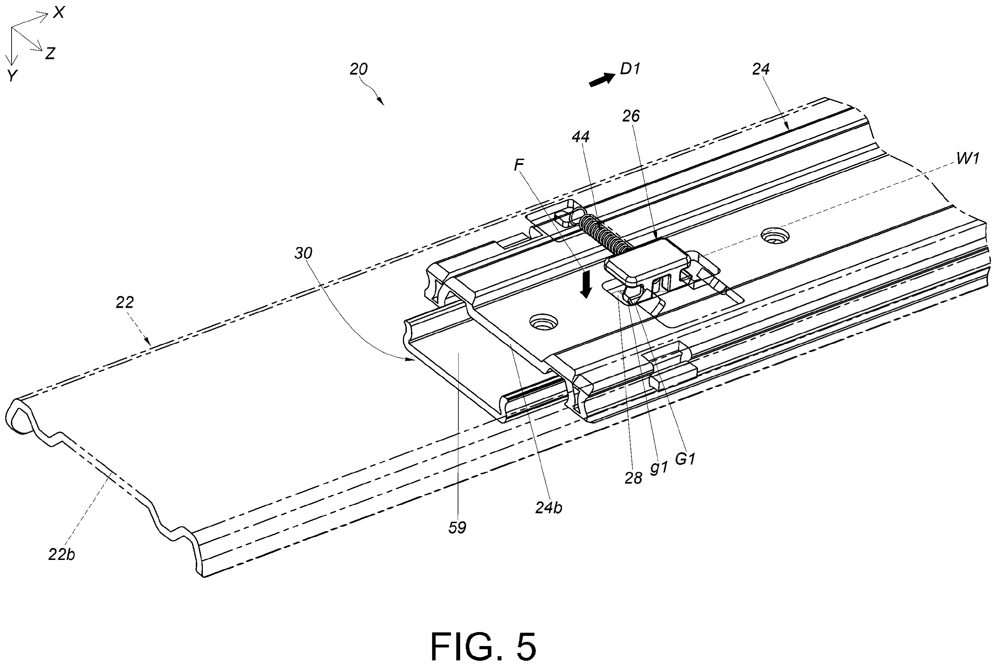

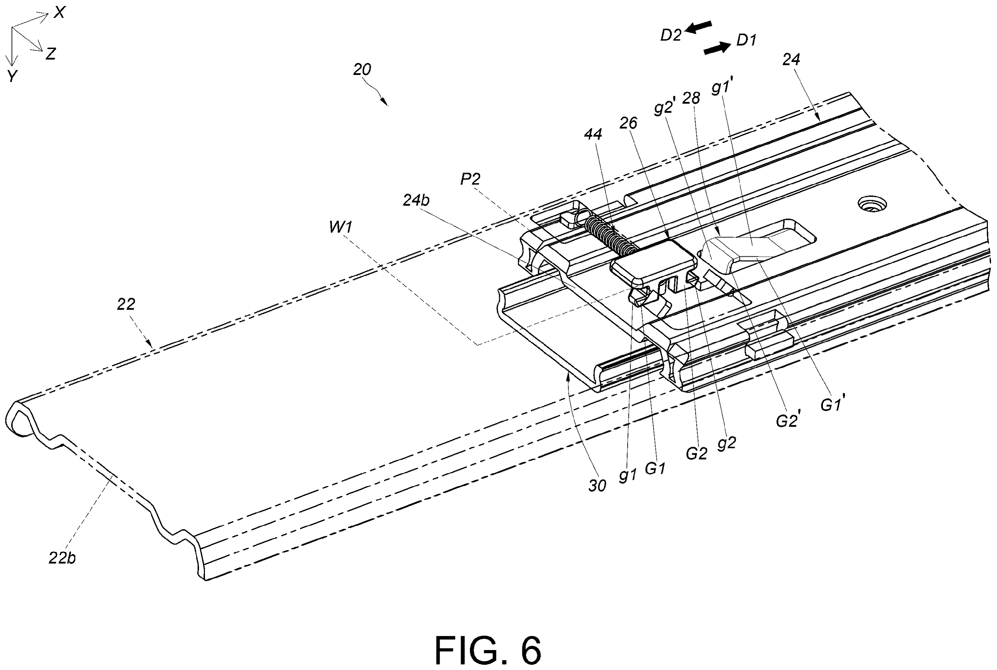

As shown in FIG. 5 and FIG. 6, if the force applied by the user to the second rail 24 along the first predetermined direction D1 is greater than the resistant force along the second predetermined direction D2 generated through the first inclined surface g1 of the first guiding structure G1 of the first auxiliary member 26 contacting the first inclined surface g1' of the first guiding feature G1' of the second auxiliary member 28, the second rail 24 is configured to further move relative to the first rail 22 from the first stop position Pa along the first predetermined direction D1. During such process, an action force F along the transverse direction is also generated through the first inclined surface g1 of the first guiding structure G1 of the first auxiliary member 26 contacting the first inclined surface g1' of the first guiding feature G1' of the second auxiliary member 28, such that the first guiding feature G1' and the second guiding feature G2' of the second auxiliary member 28 are configured to be elastically deformed toward the longitudinal wall 59 of the third rail 30 in response to the action force F (as shown in FIG. 5). Accordingly, the second auxiliary member 28 is configured to cross the first auxiliary member 26 along the first predetermined direction D1.

After the second auxiliary member 28 crosses the first auxiliary member 26 along the first predetermined direction D1, the second auxiliary member 28 is no longer elastically deformed, such that the first guiding feature G1' and the second guiding feature G2' of the second auxiliary member 28 are configured to tilt away from the longitudinal wall 59 of the third rail 30 to return to their original state. The second rail 24 can be further moved relative to the first rail 22 to a second predetermined position P2 (such as an extended position as shown in FIG. 6, but the present invention is not limited thereto) . Correspondingly, when the second auxiliary member 28 crosses the first auxiliary member 26 along the first predetermined direction D1, the speed of the second rail 24 relative to the first rail 22 along the first predetermined direction D1 is reduced, in order to prevent the second rail from moving too fast and causing unexpected impact.

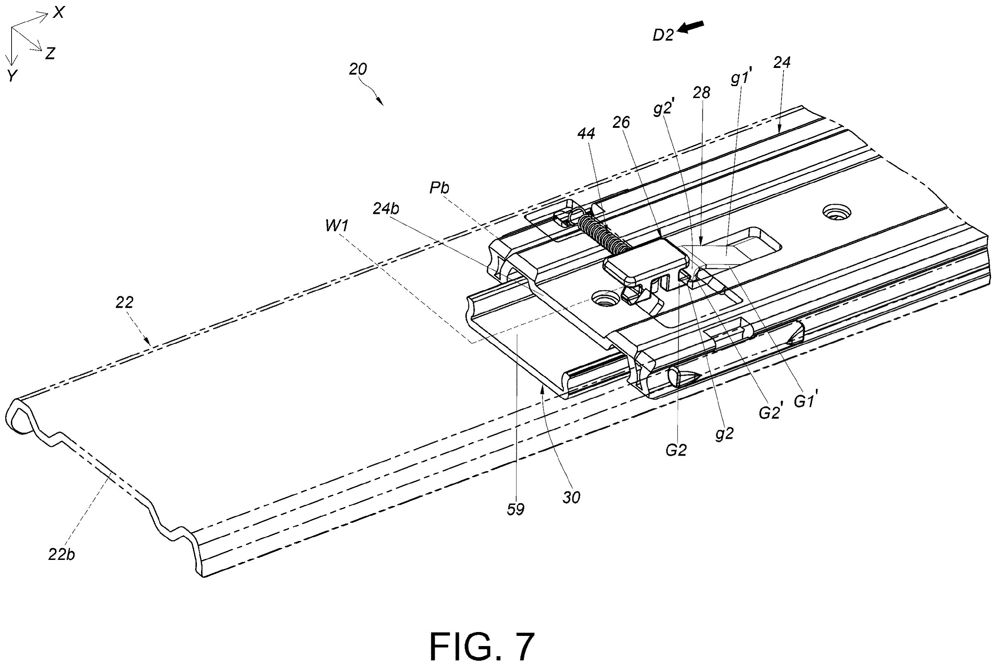

As shown in FIG. 7, during a process of the second rail 24 being longitudinally moved relative to the first rail 22 from the second predetermined position P2 along the second predetermined direction D2 with the first auxiliary member 26 being located at the first working position W1, the second inclined surface g2 of the second guiding structure G2 of the first auxiliary member 26 and the second inclined surface g2' of the second guiding feature G2' of the second auxiliary member 28 are configured to contact each other in order to reduce speed of the second rail 24 relative to the first rail 22 along the second predetermined direction D2.

Moreover, if a force applied by the user to the second rail 24 along the second predetermined direction D2 is not greater than a resistant force along the first predetermined direction D2 generated through the second inclined surface g2 of the second guiding structure G2 of the first auxiliary member 26 contacting the second inclined surface g2' of the second guiding feature G2' of the second auxiliary member 28, the movement of the second rail 24 relative to the first rail 22 along the second predetermined direction D2 is stopped, such that the second rail 24 is stopped at a second stop position Pb (as shown in FIG. 7). According to such arrangement, the user can easily perform maintenance operations to the second rail 24 (and/or a carried object carried by the third rail 30), but the purpose of the second rail 24 being stopped at the second stop position Pb is not limited thereto.

Furthermore, if the force applied by the user to the second rail 24 along the second predetermined direction D2 is greater than the resistant force along the first predetermined direction D1 generated through the second inclined surface g2 of the second guiding structure G2 of the first auxiliary member 26 contacting the second inclined surface g2' of the second guiding feature G2' of the second auxiliary member 28, the second rail 24 is configured to further move relative to the first rail 22 from the second stop position Pb along the second predetermined direction D2. During such process, another action force along the transverse direction is also generated through the second inclined surface g2 of the second guiding structure G2 of the first auxiliary member 26 contacting the second inclined surface g2' of the second guiding feature G2' of the second auxiliary member 28, such that the first guiding feature G1' and the second guiding feature G2' of the second auxiliary member 28 are configured to be elastically deformed toward the longitudinal wall 59 of the third rail 30 in response to the aforementioned action force. Accordingly, the second auxiliary member 28 is configured to cross the first auxiliary member 26 along the second predetermined direction D2. After the second auxiliary member 28 crosses the first auxiliary member 26 along the second predetermined direction D2, the second auxiliary member 28 is no longer elastically deformed, such that the first guiding feature G1' and the second guiding feature G2' of the second auxiliary member 28 are configured to tilt away from the longitudinal wall 59 of the third rail 30 to return to their original state. Correspondingly, when the second auxiliary member 28 crosses the first auxiliary member 26 along the second predetermined direction D2, the speed of the second rail 24 relative to the first rail 22 along the second predetermined direction D2 is reduced, in order to prevent the second rail from moving too fast and causing unexpected impact.

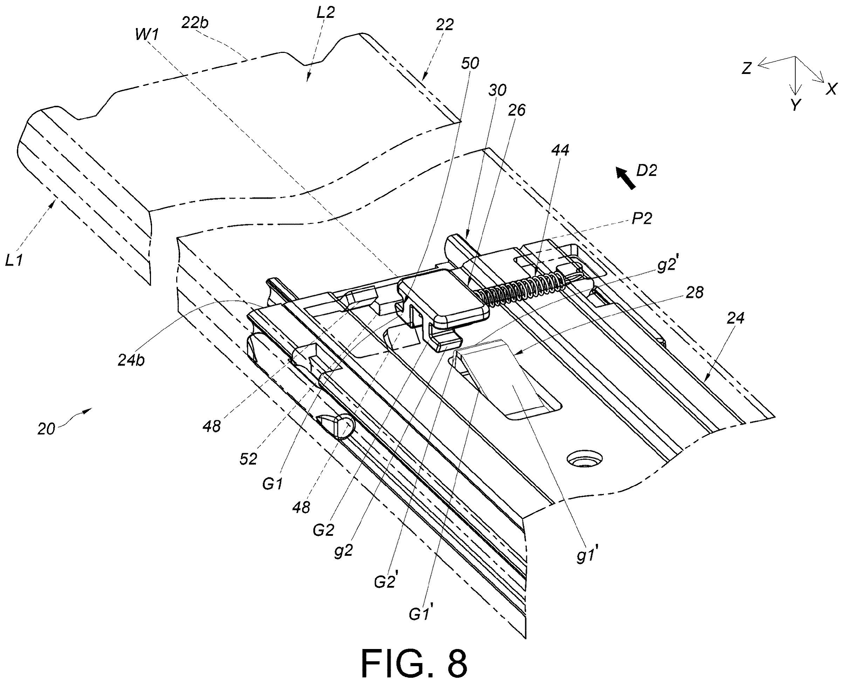

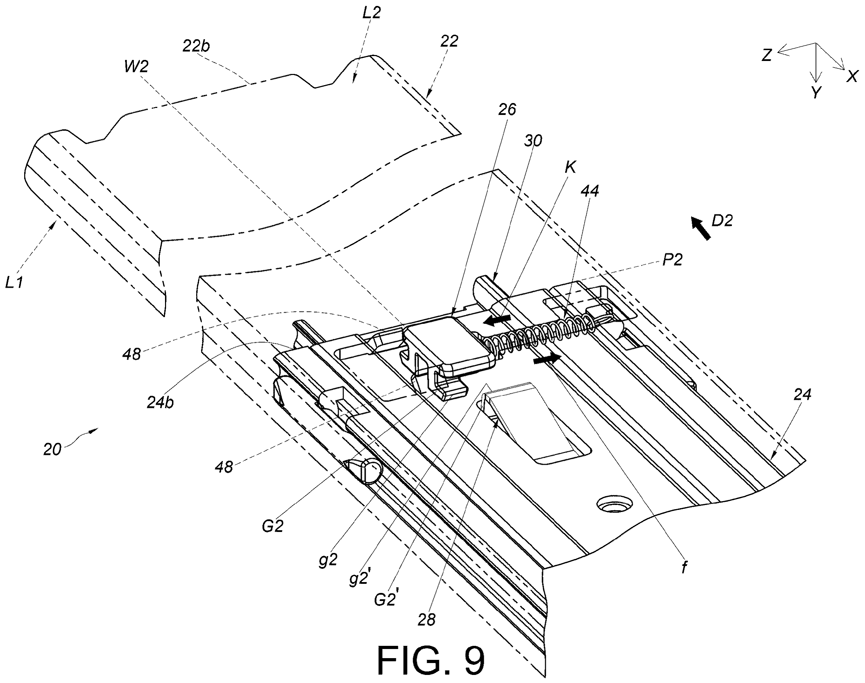

As shown in FIG. 8 and FIG.9, during a process of the second rail 24 being moved relative to the first rail 22 from the second predetermined position P2 along the second predetermined direction D2 with the first auxiliary member 26 being moved away from the first working position W1 (for example, the user applies an operating force K to the first auxiliary component 26 to move the first auxiliary member 26 from the first working position W1 as shown in FIG. 8 to a second working position W2 as shown in FIG. 9), the second guiding structure G2 of the first auxiliary member 26 does not contact with the second guiding feature G2' of the second auxiliary member 28 since the first auxiliary member 26 located at the second working position W2 is no longer aligned with the second auxiliary member 28 along the longitudinal direction (the first auxiliary member 26 located at the second working position W2 and the second auxiliary member 28 are at different heights along the height direction as shown in FIG. 9), such that the speed of the second rail 24 along the second predetermined direction D2 is not affected. Therefore, the second rail 24 can move smoothly from the second predetermined position P2 to the first predetermined position P1 relative to the first rail 22 along the second predetermined direction D2. According to such arrangement, during a process of the user moving the second rail 24 from the second predetermined position P2 along the second predetermined direction D2 relative to the first rail 22, the second guiding structure G2 of the first auxiliary member 26 does not contact with the second guiding feature G2' of the second auxiliary member 28, such that the user can effortlessly operate the second rail 24 (and the third rail 30) to move along the second predetermined direction D2 relative to the first rail 22. Moreover, such arrangement provides convenience for the user to perform operation of inspecting or assembling the slide rail assembly 20 and related components.

Preferably, when the first auxiliary member 26 is located at the second working position W2, the elastic member 44 is configured to accumulate a return elastic force f (as shown in FIG. 9). When the user stops applying the operating force K to the first auxiliary member 26, the first auxiliary member 26 is configured to return to the first working position W1 (as shown in FIG. 8) from the second working position W2 (as shown in FIG. 9) in response to the return elastic force f of the elastic member 44.

Preferably, when the operating force K along the height direction (such as the Z-axis direction) is applied to the first auxiliary member 26 to move the first auxiliary member 26 from the first working position W1 to the second working position W2, the limiting part 48 is configured to stop the first auxiliary member 26 to prevent the first auxiliary member 26 from moving excessively along the height direction (as shown in FIG. 9). The height direction is substantially perpendicular to the longitudinal direction (such as the X-axis direction) of the first rail 22.

Preferably, the user can apply the operating force K to the first auxiliary member 26 from the second side L2 of the first rail 22, in order to move the first auxiliary member 26 from the first working position W1 to the second working position W2.

Please refer to FIG. 3 and FIG. 4, when the second rail 24 is located at the first predetermined position P1 or the first stop position Pa relative to the first rail 22 and when the first auxiliary member 26 is located at the first working position W1, the user can also apply the operating force K to the first auxiliary member 26 to move the first auxiliary member 26 from the first working position W1 to the second working position W2. During a process of the second rail 24 being moved relative to the first rail 22 from the first predetermined position P1 or the first stop position Pa along the first predetermined direction D1 with the first auxiliary member 26 being moved to the second working position W2, the first inclined surface g1 of the first guiding structure G1 of the first auxiliary member 26 does not contact with the first inclined surface g1' of the first guiding feature G1' of the second auxiliary member 28 since the first auxiliary member 26 located at the second working position W2 is no longer aligned with the second auxiliary member 28 along the longitudinal direction (the first auxiliary member 26 located at the second working position W2 and the second auxiliary member 28 are at different heights along the height direction), such that the speed of the second rail 24 along the first predetermined direction D1 is not affected. Therefore, the second rail 24 can move smoothly from the first predetermined position P1 or the first stop position Pa to the second predetermined position P2 relative to the first rail 22 along the first predetermined direction D1. According to such arrangement, during a process of the user moving the second rail 24 from the first predetermined position P1 or the first stop position Pa along the first predetermined direction D1 relative to the first rail 22, the first guiding structure G1 of the first auxiliary member 26 does not contact with the first guiding feature G1' of the second auxiliary member 28, such that the user can effortlessly operate the second rail 24 (and the third rail 30) to move along the first predetermined direction D1 relative to the first rail 22. Moreover, such arrangement provides convenience for the user to perform operation of inspecting or assembling the slide rail assembly 20 and related components.

Therefore, when the first auxiliary member 26 is located at the first working position W1, the first auxiliary member 26 located at the first working position W1 is configured to contact the second auxiliary member 28 during the process of the second rail 24 being moved from the first predetermined position P1 along the first predetermined direction D1 relative to the first rail 22, or during the process of the second rail 24 being moved from the second predetermined position P2 along the second predetermined direction D2 relative to the first rail 22, in order to reduce the speed of the second rail 24 relative to the first rail 22 along the first predetermined direction D1 or the second predetermined direction D2. Preferably, if the force applied by the user to the second rail 24 is not greater than the longitudinal resistant force generated through the first auxiliary member 26 contacting the second auxiliary member 28, the second rail 24 is configured to be stopped relative to the first rail 22 at the first stop position Pa or the second stop position Pb. According to such arrangement, the user can easily perform maintenance operations to the second rail 24 (and/or the carried object carried by the third rail 30).

However, the user can operate the first auxiliary member 26 to move the first auxiliary member 26 from the first working position W1 to the second working position W2 according to requirements, such that the first auxiliary member 26 located at the second working position W2 does not contact with the second auxiliary member 28. Accordingly, the aforementioned deceleration/stopping mechanism for the second rail 24 relative to the first rail 22 can be disabled, in order to allow the user to effortlessly operate the second rail 24 to move relative to the first rail 22 along the first predetermined direction D1 or the second predetermined direction D2.

Therefore, the slide rail assembly 20 according to the embodiments of the present invention has the following technical features: the first auxiliary member 26 is operable to be moved from the first working position W1 to the second working position W2, in order to prevent the first auxiliary member 26 from contacting the second auxiliary member 28 when the second rail 24 is moved relative to the first rail 22. In other words, the user can disable the deceleration/stopping mechanism for the second rail 24 relative the first rail 22 according to requirements.

## Claims

1. A slide rail assembly (20), comprising:
a first rail (22);
a second rail (24) longitudinally movable relative to the first rail (22);
a first auxiliary member (26) movably mounted to one of the first rail (22) and the second rail (24), the first auxiliary member (26) comprising a first guiding structure and a second guiding structure; and
a second auxiliary member (28) mounted to the other one of the first rail (22) and the second rail (24), the second auxiliary member (28) comprising a first guiding feature and a second guiding feature;
**characterized in that**:
wherein during a process of the second rail (24) being moved relative to the first rail (22) from a first predetermined position along a first predetermined direction with the first auxiliary member (26) being located at a first working position, the first guiding structure of the first auxiliary member (26) and the first guiding feature of the second auxiliary member (28) are configured to contact each other in order to reduce speed of the second rail (24) relative to the first rail (22) along the first predetermined direction;
wherein when the second auxiliary member (28) crosses the first auxiliary member (26), the second rail (24) is movable relative to the first rail (22) to a second predetermined position;
wherein during a process of the second rail (24) being moved relative to the first rail (22) from the second predetermined position along a second predetermined direction opposite to the first predetermined direction with the first auxiliary member (26) being located at the first working position, the second guiding structure of the first auxiliary member (26) and the second guiding feature of the second auxiliary member (28) are configured to contact each other in order to reduce speed of the second rail (24) relative to the first rail (22) along the second predetermined direction;
wherein during a process of the second rail (24) being moved relative to the first rail (22) from the second predetermined position along the second predetermined direction with the first auxiliary member (26) being located at a second working position different from the first working position, the second guiding structure of the first auxiliary member (26) does not contact with the second guiding feature of the second auxiliary member (28).

2. The slide rail assembly of claim 1, further **characterized by** an elastic member (44); wherein the first auxiliary member (26) is configured to be held at the first working position in response to an elastic force of the elastic member (44).

3. The slide rail assembly of claim 2, **characterized in that** the first auxiliary member (26) is movably mounted to the first rail (22), and the second auxiliary member (28) is mounted to the second rail (24) ; wherein the first rail (22) has a first side and a second side opposite to each other, the first rail (22) is formed with an opening (46) communicating with the first side and the second side, and the opening (46) is configured to accommodate the first auxiliary member (26).

4. The slide rail assembly of claim 3, **characterized in that** the first rail (22) comprises a limiting part (48); wherein when the first auxiliary member (26) is operated to move from the first working position to the second working position along a height direction of the first rail (22), the limiting part (48) is configured to block the first auxiliary member (26) ; wherein the height direction is substantially perpendicular to a longitudinal direction of the first rail (22).

5. The slide rail assembly of claim 4, **characterized in that** the first auxiliary member (26) and the first rail (22) are respectively arranged with a first holding feature (50) and a second holding feature (52) fitting each other to movably mount the first auxiliary member (26) to the first rail (22).

6. The slide rail assembly of claim 5, **characterized in that** one of the first holding feature (50) and the second holding feature (52) is formed with a groove, and the other one of the first holding feature (50) and the second holding feature (52) is formed with an extension wall extended into the groove.

7. The slide rail assembly of claim 3, **characterized in that** the first side of the first rail (22) is formed with a passage (36) configured to accommodate the second rail (24).

8. The slide rail assembly of any of claims 1-7, further **characterized by** a third rail (30), wherein the second rail (24) is movably mounted between the first rail (22) and the third rail (30).

9. The slide rail assembly of claim 3, **characterized in that** the second auxiliary member (28) has a first end and a second end opposite to each other and connected to the second rail (24), and the first guiding feature and the second guiding feature of the second auxiliary member (28) are located between the first end and the second end of the second auxiliary member (28).
